# EUROPEAN PATENT SPECIFICATION

(11) **EP 2 096 153 B1**
(45) Date of publication and mention of the grant of the patent: **18.04.2012**
(21) Application number: 09002783.0
(22) Date of filing: 26.02.2009
(51) Int. Cl.: C09J 7/02

(54) **Adhesive sheet for grinding back surface of semiconductor wafer and method for grinding back surface of semiconductor wafer using the same**
Klebefolie zum Abschleifen der Oberfläche eines Halbleiterwafers und Verfahren zum Abschleifen der Oberfläche eines Halbleiterwafers unter Verwendung der Klebefolie
Feuille adhésive pour polir la surface postérieure d'une plaquette de semi-conducteur et procédé pour polir la surface postérieure d'une plaquette de semi-conducteur l'utilisant

(30) Priority: 29.02.2008 JP 2008049878
(43) Date of publication of application: 02.09.2009
(73) Proprietor: Nitto Denko Corporation, Ibaraki-shi Osaka 567-8680 (JP)
(72) Inventor: Asai, Fumiteru, Ibaraki-shi Osaka 567-8680 (JP); Kawashima, Noriyoshi, Ibaraki-shi Osaka 567-8680 (JP)
(74) Representative: Grünecker, Kinkeldey, Stockmair & Schwanhäusser

(56) References cited:
- DATABASE WPI Week 200014 Thomson Scientific, London, GB; AN 2000-156896 XP002586450 & JP 2000 017239 A (MITSUI CHEM INC) 18 January 2000 (2000-01-18)
- DATABASE WPI Week 200708 Thomson Scientific, London, GB; AN 2007-079591 XP002586452 & JP 2006 335787 A (DENKI KAGAKU KOGYO KK) 14 December 2006 (2006-12-14)

## Description

### FIELD OF THE INVENTION

The present invention relates to an adhesive sheet for grinding a back surface of a semiconductor wafer having concavity and convexity on its surface, and a method for grinding a back surface of a semiconductor wafer using the adhesive sheet.

### BACKGROUND OF THE INVENTION

When a back surface of a semiconductor wafer having concavity and convexity on its surface is ground, it is necessary to protect the surface of the wafer in order to prevent damage on the concavity and convexity on the surface of the wafer or contamination of the surface of the wafer caused by grinding dust of the wafer or grinding water. Further, since the wafer itself after grinding is thin and brittle as well as the surface of the wafer has the concavity and convexity, there is a problem that the wafer is easily damaged even by a slight external force.

In order to protect the surface of the wafer and to prevent the damage of the wafer during grinding of the back surface of the semiconductor wafer, there has been known a method of adhering an adhesive sheet to the surface of the wafer. For example, JP-A-2000-17239 proposes an adhesive film for grinding a back surface of a semiconductor wafer, in which a intermediate layer which has a JIS-A hardness of 10 to 55 and contains a thermoplastic resin is provided between a substrate layer and an adhesive layer. However, in recent years, a semiconductor wafer having a thinner thickness has been required, and at the same time, it has been demanded to keep better the in-plane thickness precision of a back surface of a wafer after grinding.

JP 2006-335787 relates to an adhesive sheet having a sequential lamination of a reinforcement layers, a soft layers, intermediate layer and an adhesive layer.

### SUMMARY OF THE INVENTION

An object of the invention is to provide an adhesive sheet for grinding a back surface of a semiconductor wafer, which can protect concavity and convexity on a surface of the wafer, prevent invasion of grinding dust or grinding water to the surface of the wafer, prevent damage on the wafer after grinding, and further keep good the in-plane thickness precision of the back surface of the wafer, when the back surface of the semiconductor wafer having the concavity and convexity on its surface is ground; and a method for grinding a back surface of a semiconductor wafer using the adhesive sheet. The object of the present invention is solved on the basis of claims 1 to 6.

Namely, the invention provides an adhesive sheet for grinding a back surface of a semiconductor wafer, which is to be adhered to a circuit forming surface of the semiconductor wafer when the back surface of the semiconductor wafer is ground, in which the adhesive sheet contains an adhesive layer, an intermediate layer and a substrate in this order from the circuit forming surface side, the intermediate layer has a JIS-A hardness of more than 55 to less than 80, and the intermediate layer has a thickness of 300 to 600 µm.

The JIS-A hardness of the intermediate layer used herein is from more than 55 to less than 80, preferably from more than 58 to less than 80, and more preferably from more than 60 to less than 80, whereby when the adhesive sheet according to the invention is adhered to the surface of the semiconductor wafer, projections on the surface of the wafer are fixed by the intermediate layer so that the damage on the projections at the time of grinding the back surface of the wafer can be prevented.
Further, the adhesive sheet has high strength even after grinding of the back surface, so that the wafer is firmly held and damage on the wafer can be inhibited. In addition, the intermediate layer acts as a buffer layer, and even when the surface of the semiconductor wafer has projections of, for example, 200 to 300 µm, it absorbs stresses acting on a place having the projections and a place having no projections on the surface of the wafer at the time of grinding from the wafer back surface side, thereby being able to inhibit deterioration of the in-plane thickness precision. Furthermore, the intermediate layer is filled between the projections on the surface of the semiconductor wafer with no space, so that it is possible to prevent grinding dust of the wafer or grinding water from invading between the surface of the wafer and the adhesive sheet. In this regard, "JIS-A hardness" referred herein is defined according to the measuring method described in the "Examples" part of the present specification described below.

Furthermore, the intermediate layer of the adhesive sheet according to the invention have a thickness of 300 to 600 µm.

When the thickness of the intermediate layer is adjusted to 300 to 600 µm, and preferably to 400 to 600 µm, follow-up properties of the adhesive sheet also to large projections on the surface of the semiconductor wafer can be improved. Further, the occurrence of cracks or dimples during grinding the back surface of the wafer can be inhibited. Furthermore, the time required for adhering the adhesive sheet can be decreased to thereby improve working efficiency. In addition, when the adhesive sheet is peeled off from the semiconductor wafer, owing to bending stress of the adhesive sheet, the thin wafer after grinding of the back surface can be prevented from being damaged.

Furthermore, in terns of wafer-holding properties, peelability from the wafer, contamination prevention of the surface of the wafer, and the like, it is preferred that the intermediate layer contain at least a thermoplastic resin.

Further, the intermediate layer of the adhesive sheet according to the invention preferably contains at least one member selected from the group consisting of: low-density polyethylene having a density of less than 0.89 g/cm³; an ethylene-vinyl acetate copolymer having a vinyl acetate content of 30 to 50% by weight; and an ethylene-alkyl acrylate copolymer having an alkyl acrylate unit content of 30 to 50% by weight, in which the alkyl group has 1 to 4 carbon atoms.

Further, in the adhesive layer of the adhesive sheet according to the invention, an acrylic adhesive is preferably used.

When the adhesive layer contains an acrylic adhesive, at the time of peeling off the adhesive sheet from the back surface of the wafer after grinding, it becomes possible to decrease contamination of the surface of the wafer caused by the adhesive.

Furthermore, it is preferred that the adhesive layer of the adhesive sheet according to the invention have a thickness of 30 to 60 µm.

When the thickness of the adhesive layer is adjusted to 30 to 60 µm, preferably to 33 to 57 µm, and more preferably to 35 to 55 µm, follow-up properties of the sheet to projections on the surface of the semiconductor wafer can be improved, whereby it becomes possible to prevent grinding dust or grinding water generated at the time of grinding the back surface of the semiconductor wafer from invading between the surface of the semiconductor wafer and the adhesive sheet.

In addition, it is preferred that the adhesive sheet according to the invention have an adhesive force of 5 to 15 N/25 mm. In this regard, "adhesive force" referred herein is defined according to the measuring method described in the "Examples" part of the present specification described below.

In the case that the adhesive force is adjusted to 5 to 15 N/25 mm, preferably to 7 to 15 N/25 mm and more preferably to 9 to 15 N/25 mm, when the adhesive sheet is peeled off from the surface of the semiconductor wafer after grinding of the back surface of the wafer, it becomes possible to peel off the adhesive sheet without damaging the projections on the surface of the semiconductor wafer Further, it is possible to prevent water from invading between the adhesive sheet and the surface of the semiconductor wafer during grinding of the back surface of the semiconductor wafer, and the load to the projections on the surface of the semiconductor wafer at the time of peeling off the adhesive sheet can be decreased.

Furthermore, the invention also provides a method for grinding a back surface of a semiconductor wafer, including adhering the above-mentioned adhesive sheet to a circuit forming surface of the semiconductor wafer, followed by grinding the back surface of the semiconductor wafer.

### BRIEF DESCRIPTION OF THE DRAWING

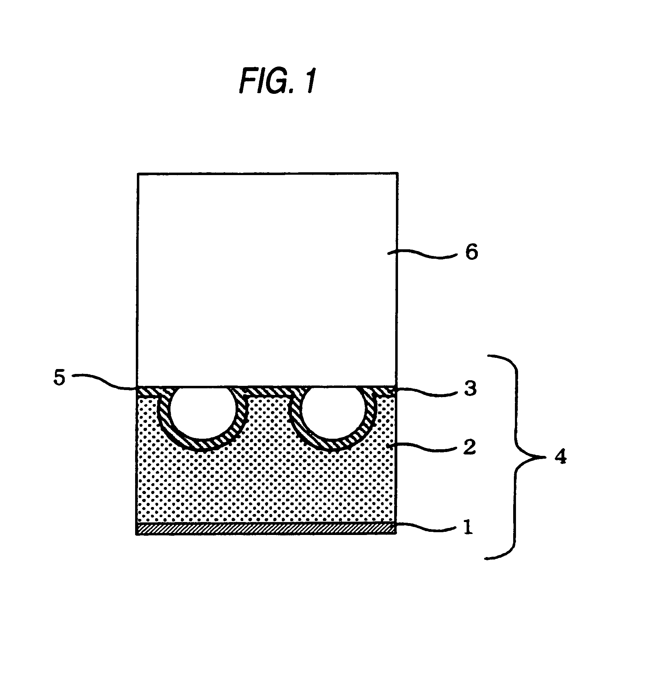

Fig. 1 is a view showing an adhesive sheet for grinding a back surface of a semiconductor wafer of the invention, which is adhered to a circuit surface of the semiconductor wafer.

### Description of Reference Numerals and Signs

- 1: substrate
- 2: intermediate layer
- 3: adhesive layer
- 4: adhesive sheet for grinding back surface of semiconductor wafer
- 5: circuit surface of semiconductor wafer
- 6: semiconductor wafer

### DETAILED DESCRIPTION OF THE INVENTION

An embodiment of the invention will be described in detail below with reference to a drawing as needed. Fig. 1 is a cross-sectional view showing an example of an adhesive sheet for grinding a back surface of a semiconductor wafer of the invention.

The adhesive sheet 4 for grinding a back surface of a semiconductor wafer of Fig. 1 is an adhesive sheet adhered to a circuit forming surface 5 of a semiconductor wafer 6, and contains an adhesive layer 3, an intermediate layer 2 and a substrate 1 in this order from the side of the circuit forming surface 5.

As materials constituting the substrate 1, there can be exemplified, for example, polyesters such as polyethylene terephthalate (PET); polyolefinic resins such as polyethylene (PE) and polypropylene (PP); polyimides (PI); Polyether ether ketones (PEEK); polyvinyl chloride-based resins such as polyvinyl chloride (PVC); polyvinylidene chloride-based resins; polyamide-based resins; polyurethanes; polystyrenic resins; acrylic resins; fluororesins; cellulosic resins; thermosetting resins; metal foils; and paper. Incidentally, as the materials constituting the substrate 1, there can also be used resins exemplified later as materials for thermoplastic resins constituting the intermediate layer 2. These materials may be used either alone or as a combination of two or more thereof. The substrate 1 may have a multilayer structure containing a plurality of layers which may be the same or different.

In terms of semiconductor wafer-holding properties, peelability from the wafer, contamination prevention of the surface of the wafer, it is preferred that the intermediate layer 2 contain at least a thermoplastic resin. The thermoplastic resin may be used either alone or as a combination of two or more thereof.

Typical examples of the thermoplastic resins include polyethylene (PE); polybutene; ethylene copolymers such as an ethylene-propylene copolymer (EPM), an ethylene-propylene-diene copolymer (EPDM), an ethylene-ethyl acrylate copolymer (EEA), an ethylene-acrylate-maleic anhydride copolymer (EEAMAH), an ethylene-glycidyl methacrylate copolymer (EGMA), an ethylene-methacrylic acid copolymer (EMAA) and an ethylene-vinyl acetate copolymer (EVA); polyolefinic copolymers; thermoplastic elastomers such as a butadiene-based elastomer, an ethylene-isoprene-based elastomer and an ester-based elastomer; thermoplastic polyester; polyamide-based resins such as a polyamide 12-based copolymer; polyurethanes; polystyrenic resins; cellophane; acrylic resins such as a polyacrylic ester and polymethyl methacrylate; and polyvinyl chloride-based resins such as a vinyl chloride-vinyl acetate copolymer. In particular, preferred is at least one member selected from an ethylene-vinyl acetate copolymer (vinyl acetate content: 30 to 50% by weight), an ethylene-alkyl acrylate copolymer having an alkyl acrylate unit content of 30 to 50% by weight (in which the alkyl group has 1 to 4 carbon atoms), and low-density polyethylene having a density of less than 0.89 g/cm³.

Further, the intermediate layer 2 may contain another component so long as the characteristics such as hardness are not impaired. Such components include, for example, a tackifier, a plasticizer, a softening agent, a filler, and an antioxidant. The intermediate layer 2 containing the thermoplastic resin may be constituted by a single layer, but may have a multilayer structure containing a plurality of layers which may be the same or different.

Although the thickness of the intermediate layer 2 can be appropriately selected so long as the wafer-holding properties and wafer-protective properties are not impaired, in the present invention, it is set to be within a range of from 300 to 600 µm, and preferably from 400 to 600 µm. When the thickness of the intermediate layer is adjusted within this range, follow-up properties of the sheet also to large projections on the surface of the semiconductor wafer can be improved. Further, the occurrence of cracks or dimples during grinding the back surface of the wafer can be inhibited. Furthermore, the time required for adhering the adhesive sheet can be decreased to thereby improve working efficiency. In this respect, in the case that the intermediate layer has a multilayer structure, the thickness of the intermediate layer means a total thickness of the plurality of layers.

Examples of the adhesives constituting the adhesive layer 3 include conventional adhesives such as a copolymer of an acrylic monomer (an acrylic adhesive), a silicone-based adhesive and a rubber-based adhesive. The adhesives can be used either alone or as a mixture of two or more thereof. In particular, an acrylic adhesive is preferably used in the adhesive layer 3. When the adhesive layer contains an acrylic adhesive, it becomes possible to decrease contamination of the surface of the wafer caused by the adhesive at the time of peeling off the adhesive sheet from the surface of the wafer after grinding.

Further, a polymer constituting the adhesive may have a crosslinked structure. Such a polymer is obtained by polymerizing a monomer mixture containing a monomer having a functional group such as a carboxyl group, a hydroxyl group, an epoxy group or an amino group (for example, an acrylic monomer) in the presence of a crosslinking agent. In the adhesive sheet having the adhesive layer 3 containing a polymer having a crosslinked structure, self-holding properties are improved, so that deformation of the adhesive sheet can be prevented and thus a flat state of the adhesive sheet can be maintained. Accordingly, the adhesive sheet can be adhered to a semiconductor wafer accurately and simply by using an automatic adhering device.

Further, as the adhesive, there can also be used an ultraviolet-curable adhesive. Such an ultraviolet-curable adhesive is obtained, for example, by blending an oligomer component which is capable of being cured by ultraviolet irradiation to form a low-adhesive material in an adhesive material. When the adhesive layer 3 is constituted by the ultraviolet-curable adhesive, plastic fluidity is imparted to the adhesive owing to the above-mentioned oligomer component. Accordingly, adhesion of the adhesive sheet becomes easy. At the same time, when the adhesive sheet is peeled off, a low-adhesive material is formed by ultraviolet irradiation, so that it can be easily peeled off from the wafer.

Typical examples of the main monomers constituting the adhesive include methyl acrylate, methyl methacrylate, ethyl acrylate, ethyl methacrylate, butyl acrylate, butyl methacrylate, 2-ethylhexyl acrylate, and 2-ethylhexyl methacrylate. These may be used either alone, or as a mixture of two or more thereof. Generally, it is preferred that the main monomer be contained in an amount ranging from 60 to 99% by weight based on the total amount of all monomers used as raw materials for the adhesive polymer.

Examples of the comonomers which are copolymerized with the main monomer and have functional groups reactable with the crosslinking agent include acrylic acid, methacrylic acid, itaconic acid, mesaconic acid, citraconic acid, fumaric acid, maleic acid, an itaconic acid monoalkyl ester, a mesaconic acid monoalkyl ester, a citraconic acid monoalkyl ester, a fumaric acid monoalkyl ester, a maleic acid monoalkyl ester, 2-hydroxyethyl acrylate, 2-hydroxyethyl methacrylate, acrylamide, merhacrylamide, t-butylaminoethyl acrylate, and t-butylaminoethyl methacrylate. One of these may be copolymerized with the above-mentioned main monomer, or two or more thereof may be copolymerized with the above-mentioned main monomer. Generally, it is preferred that the comonomer having a functional group reactable with the crosslinking agent be contained in an amount ranging from 1 to 40% by weight based on the total amount of all monomers used as raw materials for the adhesive polymer.

The thickness of the adhesive layer 3 is preferably from 30 to 60 µm, more preferably from 33 to 57 µm, and still more preferably from 35 to 55 µm.

The adhesive sheet for grinding the back surface of the semiconductor wafer in the best embodiment of the invention having the above-mentioned constitution is produced by preparing a laminated body of the substrate 1 and the intermediate layer 2, and then, forming the adhesive layer 3 on the intermediate layer 2 side of the laminated body.

Methods for forming the adhesive layer 3 on the intermediate layer 2 side of the laminated body include: a method of applying an adhesive composition to one surface of a release film, followed by drying to form the adhesive layer 3, and then, transferring the resulting adhesive layer 3 to the intermediate layer 2 side of the laminated body; and a method of applying an adhesive composition to the intermediate layer 2 side of the laminated body, followed by drying to form the adhesive layer 3.

In order to increase adhesive force between the substrate 1 and the intermediate layer 2, an adhesive layer may be additionally provided between them. Further, in order to increase adhesive force between the intermediate layer 2 and the adhesive layer 3, it is preferred that a corona treatment, or a chemical treatment be performed on a surface of the intermediate layer 2 on which the adhesive layer 3 is to be provided. Further, an undercoat layer may be provided between the intermediate layer 2 and the adhesive layer 3.

For the purpose of protecting the adhesive layer 3, a release film can also be used. Examples thereof include silicone-treated or fluorine-treated plastic films (such as a polyethylene terephthalate film and a polypropylene film); paper; and films of nonpolar materials (particularly nonpolar polymers) such as polyethylene and polypropylene.

### Examples

The invention will be described in more detail with reference to the following examples.

Adhering of Adhesive Sheet for Grinding Back Surface of Semiconductor Wafer

An adhesive sheet for grinding a back surface of a semiconductor wafer was prepared under the following conditions, and then adhered to a surface of a semiconductor wafer having a bump with a height of 200 µm formed thereon and having a thickness of 750 µm (excluding the bump) and a diameter of 20.32 cm (8 inches). DR-3000II manufactured by Nitto Seiki Co., Ltd. was used for adhering of the adhesive sheet.

### Method for Grinding Back Surface of Semiconductor Wafer

The adhesive sheet was adhered to the surface of the semiconductor wafer, and then, the back surface of the wafer was ground with a silicon wafer grinding machine manufactured by DISCO Corporation up to a thickness of 250 µm.

### Method for Peeling Off Adhesive Sheet for Grinding Back Surface of Semiconductor Wafer

After the grinding of the back surface of the semiconductor wafer was completed, an ultraviolet ray of 460 mJ/cm² was irradiated from the adhesive sheet side to cure the adhesive layer. Then, after a sheet for peeling the adhesive sheet was adhered to the adhesive sheet, the adhesive sheet was peeled off together with the sheet for peeling the adhesive sheet. HR-8500II manufactured by Nitto Seiki Co., Ltd. was used for peeling off the adhesive sheet.

### Adhesive Layer

As an adhesive used in adhesive sheets of Examples and Comparative Examples, the following one was used.

A compounded mixture containing 78 parts of ethyl acrylate, 100 parts of butyl acrylate and 40 parts of 2-hydroxyethyl acrylate was subjected to a copolymerization in a toluene solution to obtain an acrylic copolymer having a number average molecular weight of 300,000. Subsequently, 43 parts of 2-methacryloyloxyethyl isocyanate was addition reacted with this copolymer to introduce carbon-carbon double bonds into side chains of the polymer molecule. Based on 100 parts of this polymer, 1 part of a polyisocyanate-based crosslinking agent and 3 parts of an acetophenone-based photopolymerization initiator were further mixed therewith, and the resulting mixture was applied on a release-treated film, thereby preparing an adhesive layer.

### Measurement of JIS-A Hardness of Intermediate Layer

Raw material resin pellets were placed in a form, and heated at 120 to 160°C to prepare a press sheet having a thickness of 2 mm. Test pieces thus prepared were stacked to a thickness 14 mm. After stacking, measurement was made according to the method specified in JIS-K-6301-1995.

### Measurement of Adhesive Force

Measurement was made according to the method specified in JIS Z-0237-1991, except for conditions specified below. The adhesive sheet was adhered to a surface of a SUS 304-BA plate, and allowed to stand for 1 hour. A part of the adhesive sheet was chucked, and the sheet was peeled off from the surface of the SUS 304-BA plate at a peel angle of 180 degrees and a peel rate of 300 mm/min. The stress at this time was measured, and converted to the adhesive force in terms of N/25 mm.

### Example 1

As a resin for a substrate, polyethylene terephthalate was used. As a resin for an intermediate layer, an ethylene-vinyl acetate copolymer resin having a JIS-A hardness of 60 was used. From these, a laminated body of the substrate having a thickness of 3 8 µm and the intermediate layer having a thickness of 450 µm was prepared by a laminate method. Then, a corona treatment was performed on a surface of the intermediate layer on which the adhesive layer was to be provided, and the adhesive layer having a thickness of 35 µm was transferred to the corona-treated surface of the intermediate layer. After the transfer, heating was performed at 45°C for 24 hours, followed by cooling to room temperature, thereby obtaining an adhesive sheet for grinding a back surface of a semiconductor wafer. The adhesive force of the adhesive sheet was 8.5 N/25 mm.

### Example 2

As a resin for a substrate, polyethylene terephthalate was used. As a resin for an intermediate layer, an ethylene-vinyl acetate copolymer resin having a JIS-A hardness of 68 was used. From these, a laminated body of the substrate having a thickness of 38 µm and the intermediate layer having a thickness of 500 µm was prepared by a laminate method. Then, a corona treatment was performed on a surface of the intermediate layer on which the adhesive layer was to be provided, and the adhesive layer having a thickness of 35 µm was transferred to the corona-treated surface of the intermediate layer. After the transfer, heating was performed at 45°C for 24 hours, followed by cooling to room temperature, thereby obtaining an adhesive sheet for grinding a back surface of a semiconductor wafer. The adhesive force of the adhesive sheet was 9.2 N/25 mm.

### Example 3

As a resin for a substrate, polyethylene terephthalate was used. As a resin for an intermediate layer, an ethylene-vinyl acetate copolymer resin having a JIS-A hardness of 60 was used. From these, a laminated body of the substrate having a thickness of 38 µm and the intermediate layer having a thickness of 350 µm was prepared by a laminate method. Then, a corona treatment was performed on a surface of the intermediate layer on which the adhesive layer was to be provided, and the adhesive layer having a thickness of 45 µm was transferred to the corona-treated surface of the intermediate layer. After the transfer, heating was performed at 45°C for 24 hours, followed by cooling to room temperature, thereby obtaining an adhesive sheet for grinding a back surface of a semiconductor wafer. The adhesive force of the adhesive sheet was 6.3 N/25 mm.

### Example 4

As a resin for a substrate, polyethylene terephthalate was used. As a resin for an intermediate layer, an ethylene-vinyl acetate copolymer resin having a JIS-A hardness of 72 was used. From these, a laminated body of the substrate having a thickness of 388 um and the intermediate layer having a thickness of 550 µm was prepared by a laminate method. Then, a corona treatment was performed on a surface of the intermediate layer on which the adhesive layer was to be provided, and the adhesive layer having a thickness of 45 µm was transferred to the corona-treated surface of the intermediate layer. After the transfer, heating was performed at 45°C for 24 hours, followed by cooling to room temperature, thereby obtaining an adhesive sheet for grinding a back surface of a semiconductor wafer. The adhesive force of the adhesive sheet was 10.2 N/25 mm.

### Comparative Example 1

As a resin for a substrate, polyethylene terephthalate was used. As a resin for an intermediate layer, an ethylene-vinyl acetate copolymer resin having a JIS-A hardness of 38 was used. From these, a laminated body of the substrate having a thickness of 38 µm and the intermediate layer having a thickness of 450 µm was prepared by a laminate method. Then, a corona treatment was performed on a surface of the intermediate layer on which the adhesive layer was to be provided, and the adhesive layer having a thickness of 40 µm was transferred to the corona-treated surface of the intermediate layer. After the transfer, heating was performed at 45°C for 24 hours, followed by cooling to room temperature, thereby obtaining an adhesive sheet for grinding a back surface of a semiconductor wafer. The adhesive force of the adhesive sheet was 7.4 N/25 mm.

### Comparative Example 2

As a resin for a substrate, polyethylene terephthalate was used. As a resin for an intermediate layer, an ethylene-vinyl acetate copolymer resin having a JIS-A hardness of 58 was used. From these, a laminated body of the substrate having a thickness of 38 µm and the intermediate layer having a thickness of 280 µm was prepared by a laminate method. Then, a corona treatment was performed on a surface of the intermediate layer on which the adhesive layer was to be provided, and the adhesive layer having a thickness of 25 µm was transferred to the corona-treated surface of the intermediate layer. After the transfer, heating was performed at 45°C for 24 hours, followed by cooling to room temperature, thereby obtaining an adhesive sheet for grinding a back surface of a semiconductor wafer. The adhesive force of the adhesive sheet was 4.8 N/25 mm.

### Comparative Example 3

As a resin for a substrate, polyethylene terephthalate was used. As a resin for an intermediate layer, an ethylene-vinyl acetate copolymer resin having a JIS-A hardness of 38 was used. From these, a laminated body of the substrate having a thickness of 38 µm and the intermediate layer having a thickness of 250 µm was prepared by a laminate method. Then, a corona treatment was performed on a surface of the intermediate layer on which the adhesive layer was to be provided, and the adhesive layer having a thickness of 20 µm was transferred to the corona-treated surface of the intermediate layer. After the transfer, heating was performed at 45°C for 24 hours, followed by cooling to room temperature, thereby obtaining an adhesive sheet for grinding a back surface of a semiconductor wafer. The adhesive force of the adhesive sheet was 4.2 N/25 mm.

The constitutions of the adhesive sheets in these Examples and Comparative Examples and measurement results of the adhesive force are shown in Table 1.

**Table 1**

| | Substrate Film | | Thermoplastic Resin | | | Adhesive Layer | |
|---|---|---|---|---|---|---|---|
| | Material | Thickness (µm) | Material | Thickness (µm) | JIS-A Hardness | Thickness (µm) | Adhesive Force (N/25 mm) |
| Example 1 | PET | 38 | EVA | 450 | 60 | 35 | 8.5 |
| Example 2 | PET | 38 | EVA | 500 | 68 | 35 | 9.2 |
| Example 3 | PET | 38 | EVA | 350 | 60 | 45 | 6.3 |
| Example 4 | PET | 38 | EVA | 550 | 72 | 45 | 10.2 |
| Comparative Example 1 | PET | 38 | EVA | 450 | 38 | 40 | 7.4 |
| Comparative Example 2 | PET | 38 | EVA | 280 | 58 | 25 | 4.8 |
| Comparative Example 3 | PET | 38 | EVA | 250 | 38 | 20 | 4.2 |

Further, there were examined the presence or absence of water invasion between the adhesive sheet and the surface of the wafer after the back surface of the semiconductor wafer was ground, and the presence or absence of a wafer crack caused by grinding of the back surface of the wafer. The difference between the maximum thickness and the minimum thickness of the wafer after grinding was taken as the in-plane thickness precision. The case where it was 20 µm or more was evaluated as having a practical problem. The results thereof are shown in Table 2.

**Table 2**

| | Wafer Crack during Grinding | Water Invasion during Grinding | In-Plane Thickness Precision (µm) |
|---|---|---|---|
| Example 1 | Not observed | No water invasion was observed | 14 |
| Example 2 | Not observed | No water invasion was observed | 17 |
| Example 3 | Not observed | No water invasion was observed | 16 |
| Example 4 | Not observed | No water invasion was observed | 17 |
| Comparative Example 1 | Not observed | No water invasion was observed | 28 |
| Comparative Example 2 | Observed | Water invasion was observed | 15 |
| Comparative Example 3 | Observed | Water invasion was observed | 25 |

This application is based on Japanese patent application No. 2008-049878 filed February 29, 2008.

## Claims

1. An adhesive sheet for grinding a back surface of a semiconductor wafer, which is to be adhered to a circuit forming surface of the semiconductor wafer when the back surface of the semiconductor wafer is ground,
wherein the adhesive sheet comprises an adhesive layer, an intermediate layer and a substrate in this order from the circuit forming surface side,
wherein the intermediate layer has a JIS-A hardness of more than 55 to less than 80, and
wherein the intermediate layer has a thickness of 300 to 600 µm.

2. The adhesive sheet according to claim 1, wherein the intermediate layer comprises at least one member selected from the group consisting of: a low-density polyethylene having a density of less than 0.89 g/cm³; an ethylene-vinyl acetate copolymer having a vinyl acetate content of 30 to 50% by weight; and an ethylene-alkyl acrylate copolymer having an alkyl acrylate unit content of 30 to 50% by weight, wherein the alkyl group has 1 to 4 carbon atoms.

3. The adhesive sheet according to claim 1, wherein the adhesive layer comprises an acrylic adhesive.

4. The adhesive sheet according to claim 1, wherein the adhesive layer has a thickness of 30 to 60 µm.

5. The adhesive sheet according to claim 1, wherein the adhesive sheet has an adhesive force of 5 to 15 N/25 mm.

6. A method for grinding a back surface of a semiconductor wafer, comprising adhering the adhesive sheet according to claim 1 to a circuit forming surface of the semiconductor wafer, followed by grinding the back surface of the semiconductor wafer.

## Patentansprüche

1. Klebefolie zum Schleifen einer rückseitigen Oberfläche eines Halbleiterwafers, welche auf eine einen Schaltkreis bildende Oberfläche des Halbleiterwafers aufgeklebt werden soll, wenn die rückseitige Oberfläche des Halbleiterwafers geschliffen wird,
wobei die Klebefolie eine Klebstoffschicht, eine Zwischenschicht und ein Substrat in dieser Reihenfolge von der Seite der einen Schaltkreis bildenden Oberfläche her umfasst,
wobei die Zwischenschicht eine JIS-A-Härte von mehr als 55 bis weniger als 80 aufweist, und
wobei die Zwischenschicht eine Dicke von 300 bis 600 µm aufweist.

2. Klebefolie nach Anspruch 1, wobei die Zwischenschicht wenigstens einen Bestandteil umfasst, ausgewählt aus der Gruppe bestehend aus: einem Polyethylen niedriger Dichte mit einer Dichte von weniger als 0,89 g/cm³; einem Ethylen-Vinylacetat-Copolymer mit einem Vinylacetatgehalt von 30 bis 50 Gew.-%; und einem Ethylen-Alkylacrylat-Copolymer mit einem Alkylacrylateinheitsgehalt von 30 bis 50 Gew.-%, wobei die Alkylgruppe 1 bis 4 Kohlenstoffatome aufweist.

3. Klebefolie nach Anspruch 1, wobei die Klebstoffschicht einen Acrylklebstoff umfasst.

4. Klebefolie nach Anspruch 1, wobei die Klebstoffschicht eine Dicke von 30 bis 60 µm aufweist.

5. Klebefolie nach Anspruch 1, wobei die Klebefolie eine Klebekraft von 5 bis 15 N/25 mm aufweist.

6. Verfahren zum Schleifen einer rückseitigen Oberfläche eines Halbleiterwafers, umfassend das Aufkleben der Klebefolie nach Anspruch 1 auf eine einen Schaltkreis bildende Oberfläche des Halbleiterwafers, gefolgt vom Schleifen der rückseitigen Oberfläche des Halbleiterwafers.

## Revendications

1. Feuille adhésive pour polir la surface postérieure d'une plaquette de semi-conducteur, qui doit être fixée sur une surface formant circuit de la plaquette de semi-conducteur lorsque la surface postérieure de la plaquette de semi-conducteur est polie,
dans laquelle la feuille adhésive comprend une couche adhésive, une couche intermédiaire et un substrat dans cet ordre en partant de la surface formant circuit,
dans laquelle la couche intermédiaire a une dureté JIS-A supérieure à 55 et inférieure à 80, et
dans laquelle la couche intermédiaire a une épaisseur de 300 à 600 µm.

2. Feuille adhésive selon la revendication 1, dans laquelle la couche intermédiaire comprend au moins un élément choisi dans le groupe constitué de : un polyéthylène de faible densité ayant une densité inférieure à 0,89 g/cm³ ; un copolymère éthylène-acétate de vinyle ayant une teneur en acétate de vinyle de 30 à 50 % en poids ; et un copolymère éthylène-acrylate d'alkyle ayant une teneur en unités acrylate d'alkyle de 30 à 50 % en poids, le groupe alkyle comportant 1 à 4 atomes de carbone.

3. Feuille adhésive selon la revendication 1, dans laquelle la couche adhésive comprend un adhésif acrylique.

4. Feuille adhésive selon la revendication 1, dans laquelle la couche adhésive a une épaisseur de 30 à 60 µm.

5. Feuille adhésive selon la revendication 1, dans laquelle la feuille adhésive a une force d'adhésion de 5 à 15 N/25 mm.

6. Procédé pour polir la surface postérieure d'une plaquette de semi-conducteur, comprenant la fixation de la feuille adhésive selon la revendication 1 sur
une surface formant circuit de la plaquette de semi-conducteur, suivie du polissage de la surface postérieure de la plaquette de semi-conducteur.
